(19) Europäisches Patentamt / European Patent Office / Office européen des brevets

(11) **EP 4 567 514 A2**

(12) **EUROPEAN PATENT APPLICATION**

(43) Date of publication:
**11.06.2025 Bulletin 2025/24**

(21) Application number: 25166653.3

(22) Date of filing: **27.03.2025**

(51) International Patent Classification (IPC):
*G03F 7/00* *(2006.01)*

(52) Cooperative Patent Classification (CPC):
**G03F 7/70141; G03F 7/70258; G03F 7/70525**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: ASML Netherlands B.V.
**5500 AH Veldhoven (NL)**

(72) Inventors:
- **DIRKX, Nic, Jasper**
  **5500 AH Veldhoven (NL)**
- **VAN DE WAL, Marinus, Maria, Johannes**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **EXPOSURE APPARATUS POSITION CONTROL**

(57) A method of positioning N modules in an exposure apparatus, wherein N > 2, the method comprises controlling a position of each of the N modules, comprising, for at least one of the N modules, feeding through a position error of the at least one of the N modules to at least two other ones of the N modules. The feeding through comprises multiplying the position errors by a feed through filter matrix, wherein a non-diagonal term in the feed through filter matrix provides a feed through parameter from an error signal of a respective one of the N modules to another one of the N modules.

Fig. 3

**Description**

FIELD

The present invention relates to methods of positioning N modules in an exposure apparatus, wherein N > 2. Furthermore, the present invention relates to a position controller configured to control a position of each one of N modules of an exposure apparatus, wherein N > 2 and to an exposure apparatus comprising said position controller.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus may form a complex systems of systems (SoS), wherein a performance at system-level is determined by a combined performance of the different systems comprised in the system of systems. Each system in the system of systems may be identified as a module. For example, in a lithographic apparatus that makes use of reflective mirror optics, modules may be formed by the substrate table, the support that supports the patterning device, as well as by the mirrors of the projection system. Each one of the modules may be provided with a corresponding control system to control an output, e.g. a position, of the respective module. A system-level performance metric error may be determined from a combination of the outputs of the modules, e.g. in the example of the lithographic apparatus a position of the substrate table, a position of the patterning device support and positions of each of the mirrors of the projection system.

System-level control performance specifications may be cascaded down into specifications on the level of the individual modules. The control systems of the modules may be designed to meet these individual requirements at module level.

EP4455784A1 discloses an error feed through. An optical system, such as in a lithographic apparatus, comprises a first component, a second component and a third component. An image positioning error of the first component is fed through to a control loop of the second component to at least partly compensate the image positioning error of the first component. An image positioning error of the second component is fed through to a control loop of the third component to at least partly compensate the image positioning error of the second component. An overall image positioning error may be reduced.

Although the above described error feed through may assist to reduce an overall position error, error contributions of individual modules may tend to accumulate. Moreover, an error contribution of the third component, i.e. the last component that received the feedthrough, may not be compensated.

Due to the accumulation of errors, resulting, remaining errors may be relatively high, causing module-level performance requirements tend to be very demanding.

SUMMARY

The present invention aims to further enhance position control of the exposure apparatus.

According to an aspect of the invention, there is provided a method of positioning N modules in an exposure apparatus, wherein N > 2, the method comprising controlling a position of each of the N modules, comprising, for at least one of the N modules, feeding through a position error of the at least one of the N modules to at least two other ones of the N modules.

According to another aspect of the invention, there is provided a position controller configured to control a position of each one of N modules of an exposure apparatus, wherein N > 2, wherein the position controller is configured to, for at least one of the N modules, feed through a position error of the at least one of the N modules to at least two other ones of the N modules.

According to yet another aspect of the invention, there is provided an exposure apparatus comprising said position controller, wherein the N modules comprise at least N of a substrate table configured to support a substrate, a support configured to support a patterning device, a first optical element, a second optical element, a third optical element, a fourth optical element, a fifth optical element, a sixth optical element, a seventh optical element and an eighth optical element.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2A - 2C depict embodiments of plural modules and interconnections between the modules;
- Figure 3 depicts a control scheme according to an embodiment of the invention;
- Figure 4 depicts frequency-domain diagrams of an example of the controller as comprised in the control scheme according to Figure 3;
- Figure 5 depicts frequency-domain diagrams of resulting errors of the 4 modules in the control scheme according to Figure 3 when using the controller according to Figure 4;
- Figure 6 depicts magnitude and phase of embodiments of an initial PID and PD controller;
- Figure 7A and 7B depict time diagrams of an error resulting from the initial PID an PD controllers in accordance with Figure 6.

DETAILED DESCRIPTION

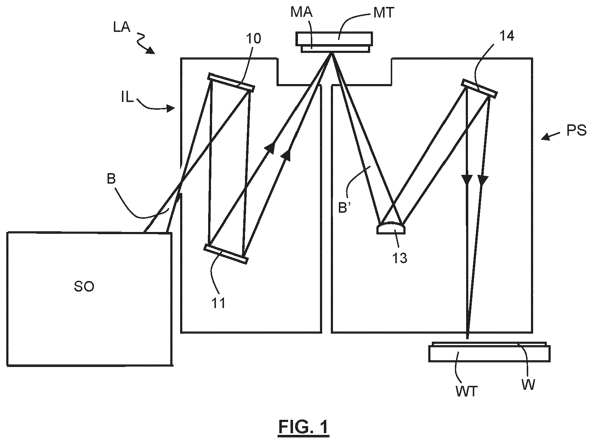

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

As described above, a lithographic apparatus may form a complex systems of systems (SoS), wherein a performance at system-level is determined by a combined performance of the different systems comprised in the system of systems. Each system in the system of systems may be identified as a module. For example, in a lithographic apparatus that makes use of reflective mirror optics, modules may be formed by the substrate table, the support that supports the patterning device, as well as by the mirrors of the projection system. Each one of the modules may be provided with a corresponding control system to control an output, e.g. a position, of the respective module. A system-level performance metric error may be determined from a combination of the outputs of the modules, e.g. in the example of the lithographic apparatus a position of the substrate table, a position of the patterning device support and positions of each of the mirrors of the projection system.

System-level control performance specifications may be cascaded down into specifications on the level of the individual modules. The control systems of the modules may be designed to meet these individual requirements at module level.

Due to the accumulation of errors, module-level performance requirements tend to be very demanding.

The present invention aims to further enhance position control of the exposure apparatus.

According to an aspect of the invention, there is provided a method of positioning N modules in an exposure apparatus, wherein N > 2, the method comprising controlling a position of each of the N modules, comprising, for at least one of the N modules, feeding through a position error of the at least one of the N modules to at least two other ones of the N modules.

By feeding through a position error of one module to at least two other modules, an overall system performance may be enhanced. By the feed through of the position error of one of the modules to at least two other one of the modules, the contribution of the position error of the one of the modules may at least partly be compensated by the two other one of the modules to which the position error is fed through. As the position errors of the at least one module is fed through to at least two other modules, the position error of the at least one module may at least partly be compensated by the at least two other modules, which may reduce an effective position error contribution of the at least one module to an overall error. Accordingly, overall accuracy be enhanced, or phrased differently, when seeking a certain system level specification, the specifications required to be achieved by the at least one module may be slightly relaxed.

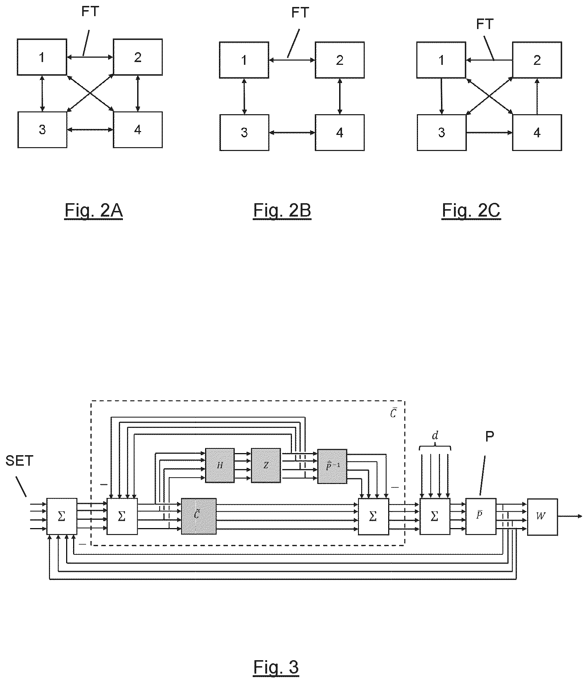

Figure 2A - 2C disclose a block schematic view of the modules of the exposure apparatus. In each example, the system comprises 4 modules, indicated by 1, 2, 3 and 4. The feed through of the error of one module to another module is schematically indicated by an arrow. A one directional arrow indicates a feedthrough from one module to another module according to the direction of the arrow. A two directional arrow indicates a feedthrough from one module to another module and a feedthrough from the other module to the one module.

For example, figure 2A depicts a configuration whereby a position error of module 1 is fed through to module 2, module 3 as well as module 4. Further, a position error of module 2 is fed through to module 1, module 3 as well as module 4. A position error of module 3 is fed through to module 1, module 2 as well as module 4. A position error of module 4 is fed through to module 1, module 2 as well as module 3.

As another example, figure 2B depicts a configuration whereby a position error of module 1 is fed through to module 2 as well as module 3. A position error of module 2 is fed through to module 1 as well as module 4. A position error of module 3 is fed through to module 1 as well as module 4. A position error of module 4 is fed through to module 2 as well as module 3.

As yet anther example, figure 2C depicts a configuration whereby a position error of module 1 is fed through to module 3 as well as module 4. Further, a position error of module 2 is fed through to module 1 as well as module 3. A position error of module 3 is fed through to module 2 as well as module 4. A position error of module 4 is fed through to module 1 as well as module 2.

Accordingly, in figures 2A - 2C, each arrow from one of the modules 1 - 4 to an other one of the modules 1 - 4 may be understood so as to represent a feeding through of a position error from the one of the modules 1 - 4 to the other one of the modules 1 - 4.

Although the above examples refer to 4 modules, any other plurality of number N of modules may apply, whereby N > 2, for example N=3, N=5, N=6, N=7, N=8, N=9, N=10 or any other number. It is noted that the described feed through controller structure may also be applied for a system with two modules, i.e. N=2.

In an embodiment, the method comprises controlling a position of each of the N modules, comprising, for each one of the N modules, feeding through a position error of each one of the N modules to at least two other ones of the N modules. A position error of each one of the N modules may be reduced, as the position error of each one of the N modules is fed through to at least two other ones of the N modules.

In an embodiment, the method comprises controlling a position of each of the N modules, comprising, for at least one of the N modules, feeding through a position error of the at least one of the N modules to N-1 other ones of the N modules. A position error of the at least one of the N modules may be reduced to a large extent, as the position error of the at least one of the N modules is fed through to each of the other ones of the N modules.

In an embodiment, the method comprises controlling a position of each of the N modules, comprising, for each one of the N modules, feeding through a position error of each one of the N modules to N-1 other ones of the N modules. A position error of each one of the N modules may be reduced to a large extent, as the position error of each one of the N modules is fed through to each of the other ones of the N modules.

In an embodiment, the feeding through comprises multiplying the position errors by a feed through filter matrix, the feed through filter matrix being an N x N matrix, wherein a non-diagonal term in the feed through filter matrix provides a feed through parameter from an error signal of a respective one of the N modules to another one of the N modules. The non-diagonal term of the feed through matrix may provide a feed through parameter to another module, hence enabling to reduce an effect of an error to a high extent, as the error at a particular one of the modules may be mitigated by plural of the other ones of the modules. For example, the error signal of each one of the N modules may be fed through to N-1 other ones of the N modules, as schematically illustrated in Figure 2A for the example N = 4. The feed through parameters

The feeding through may comprise multiplying an output of the feed through filter matrix by an inverse of a parametric plant model matrix. The parametric model may be obtained from first principles modeling or system identification. The inverse of the plant model matrix may apply if the model has square dimensions. In case the parametric plant model matrix has non-square dimensions, an approximated inverse could be used: invP = minimize $\| I - P \ast invP \|$.

The feeding through may comprise subtracting the output of the inverse of the parametric plant model matrix from the closed loop controller output signals of closed loop position controllers of the N modules. The feeding through may further comprise subtracting the output of the feed through filter matrix from the N error signals of the N modules. The subtracting the output of the feed through filter matrix from the N error signals may prevent the closed loop controller of each module from regulating away the feed through signal, i.e. from regulating away the output of the inverse of the parametric plant model matrix as subtracted from the closed loop controller output signals of the closed loop controllers of the N modules.

The above will be further explained with reference to Figure 3. Figure 3 depicts a control scheme which may implement the method according to an embodiment of the invention. Setpoints SET for each module are provided at Setpoint inputs. For each module, a respective setpoint may be input. The setpoints may for example comprise position setpoints representing setpoint positions of the modules. The setpoints are provided to a closed loop control of plant P. Plant P may be understood as a system comprising the N modules.

The plant P may be represented by matrix P, which may be denoted as

$$\bar{P} = \begin{bmatrix} P_{11} & \cdots & P_{1N} \\ \vdots & \ddots & \vdots \\ P_{N1} & \cdots & P_{NN} \end{bmatrix},$$

where diagonal entries $P_{ii}$, $i = 1,.. N$ of the matrix $\bar{P}$ may represent the individual subsystems (i.e. the modules), and the off-diagonals $P_{ij}$, $j = 1, ... N, j \neq i$ of the matrix $\bar{P}$ may represent a dynamic interaction between the modules (e.g., parasitic crosstalk).

As the matrix $\bar{P}$ may represent the modules as well as the interaction between the modules, such as crosstalk, the modules as well as the interactions between the modules may be taken into account.

Each module may be provided with an individual module-level closed loop controllers $C_i$ which may provide closed loop control of the respective module according to the setpoint of the respective module. The individual module-level closed loop controllers $C_i$ and stacked into closed loop controller matrix C

$$C = \begin{bmatrix} C_1 & 0 & 0 \\ 0 & \ddots & 0 \\ 0 & 0 & C_N \end{bmatrix}.$$

In the above example, the non diagonal terms of the closed loop controller matrix C are zero. In alternative embodiments, some or all of the off diagonal terms in the closed loop controller matrix may be non-zero, e.g. to take account of existing error feed through.

An initial closed loop control may be provided by the closed loop controller matrix C and the plant P, whereby N outputs of the plant P, i.e. the N outputs of the N modules of the plant P are fed back and subtracted from the N setpoints of the N modules to provide N error signals (one error signal per module), which error signals are provided to the closed loop controller matrix C comprising N individual module-level closed loop controllers $C_i$ whereby N controller output signals of the N individual module-level closed loop controllers $C_i$ are provided as inputs to the plant P.

A combined error z may be determined from a weighted sum of the N outputs of the N modules, the outputs being denoted as $y_i$, $i = 1, ... N$, of the $N$ modules,

$$z = w_1 y_1 + w_2 y_2 + \cdots + \cdots w_N y_N,$$

where weighting factors $w_1 .... w_N$ of the modules 1 ... N may be comprised in the vector $W = [w_1 ... w_N]$. The multiplication of the outputs $y_1 ... y_N$ of the N modules by the respective weighting factors $w_1 .... w_N$ of the vector W may provide the contributions of the N modules to the combined error z. The above mentioned expression of the combined error z applies to the situation in which the submodules $P_{ii}$ are single input single output, SISO. If these are multiple input multiple output MIMO systems, MIMO notations may be used. In such case, each $w_i$ becomes a matrix, and that each $y_i$ becomes a vector.

The combined error as a result of a disturbance vector $d_1 ... d_N$ for the N modules may be expressed by:

$$z = w_1 SP_1 d_1 + \cdots + w_N SP_N d_N,$$

where $SP_i = (I + P_{ii}C_i)^{-1} P_{ii}$ is a Process Sensitivity function and $d_i$ the external input disturbances.

As depicted in Figure 3, the N error signals, i.e. the N inputs of the closed loop controller matrix C are provided to a feedthrough filter matrix H. The feedthrough filter matrix H may comprise an N x N matrix. A non-diagonal term in the feed through filter matrix may provide a feed through parameter from an error signal of a respective one of the N modules to another one of the N modules. As mentioned above, the NxN dimension applies when each submodule is SISO. Otherwise the dimensions of said matrix may become (N*Na)x(N*Na) with Na the number of axes within a module, assuming that each module has a same number of axes. The FT filter matrix H may have a hollow structure (zero diagonal), as the diagonal terms would provide a feed through of the error of one module onto the same module. In alternative embodiments, the feed through filter matrix may be full.

$$H = \begin{bmatrix} H_{11} & \dots & H_{1N} \\ \vdots & \ddots & \vdots \\ H_{N1} & \dots & H_{NN} \end{bmatrix}, \qquad H_{ii} = 0, \quad i \in [1, N].$$

A non-zero cross-term $H_{ij}$ may indicate that module $j$ feeds through its (filtered) error to module $i$. As such, the selection of $H_{ij}$ may be used to create a specific interconnection structure, e.g., to realize any of the forms in Figure 2A - 2C. The cross terms, i.e. the non-diagonal terms in the matrix H may enable to define a feed through from any one of the N modules to any other one of the N modules.

A parametric model of the plant P, i.e. a parametric model of the system comprising the N modules may be provided. In Figure 3, the parametric model of the plant P is denoted as $\hat{\bar{P}}$ The parametric model may be determined from $\bar{P}$, and may be obtained from first principles modeling or system identification.

As depicted in Figure 3, the output of the feed through filter matrix H is multiplied by an inverse of a parametric plant model matrix $\hat{\bar{P}}$. As mentioned above, in case the parametric plant model matrix has non-square dimensions, an approximated inverse may be used: invP = minimize ∥ I - P*invP ∥.

The feed through filter matrix may further comprise a stability and causality matrix Z. The stability and causality matrix Z may comprise a filter that ensures that the inverse of a parametric plant model matrix $\hat{\bar{P}}$ multiplied by Z is stable and causal/proper.

An output of the inverse of the parametric plant model matrix is subtracted from the closed loop controller output signals of closed loop position controllers of the N modules. The feeding through may further comprise subtracting the output of the feed through filter matrix from the N error signals of the N modules. As described above, the subtracting the output of the feed through filter matrix from the N error signals may prevent the closed loop controller of each module from regulating away the feed through signal, i.e. from regulating away the output of the inverse of the parametric plant model matrix as subtracted from the controller output signals of the closed loop controllers of the N modules.

The control method as described with reference to Figure 3 may provide an improved combined performance of the N modules. Furthermore, the control method may provide an improved dynamic performance, providing e.g. an improvement in settling behavior. The enhanced combined performance and enhanced settling behavior may enable to enhance overall system specifications of the combined modules. Still further, when taking a predetermined static and/or dynamic performance as a starting point, said performance may be achieved on the basis of a lower, i.e. more relaxed, performance of the modules as such, which may promote a reduction in cost of goods as lower design specifications of the individual modules may be used as a starting point.

A multiple input, multiple output model may be provided as described above.

The feed through filter matrix H may comprise a static feed through filter matrix (such as in the present example $H_w$) and a dynamic feed through filter matrix (such as in the present example $H_{dyn}$). The static feed through filter matrix may determine an interconnectivity, while the dynamic feed through filter matrix may provide for a dynamic tuning. For example, the dynamic feed through filter matrix may comprise a notch filter and/or a low-pass filter. The dynamic feed through filter matrix may comprise diagonal filter matrix terms, while non-diagonal filter matrix terms may comprise zeros.

An example of the static feed through filter matrix will be described below.

In an embodiment, the static feed through filter matrix may be formed using the weighting factors, as follows:

$$H_w = \left( - \begin{bmatrix} \frac{1}{w_1} \\ \vdots \\ \frac{1}{w_N} \end{bmatrix} W + I \right) \frac{1}{N-1},$$

wherein the weighting factors $w_1$ .... $w_N$ of the modules 1 ... N may be comprised in the vector $W = [w_1 \cdots w_N]$.

The above static feed through filter matrix on the basis of the weighting factors may evenly reduce the contributions to the combined error, resulting in a combined error $z_{FT}$ according to the below formula:

$$z_{FT} = w_1\big(1 - H_{dyn,11}\big)SP_1 d_1 + \cdots + \big(1 - H_{dyn,NN}\big)w_N SP_N d_N.$$

wherein H = $H_w$*$H_{dyn}$, where $H_{dyn}$ is diagonal matrix with $H_{dyn,11}$ ... $H_{dyn,NN}$ on its diagonal entries.

As the terms in the dynamic feed through filter matrix may have a value close to 1 at lower frequencies, it follows that the resulting combined error may be significantly reduced, in particular at lower frequencies.

According to another embodiment, there is provided a position controller configured to control a position of each one of N modules of an exposure apparatus, wherein N > 2, wherein the position controller is configured to, for at least one of the N modules, feed through a position error of the at least one of the N modules to at least two other ones of the N modules.

According to yet another embodiment, there is provided an exposure apparatus comprising the position controller according to the invention.

With the position controller and the exposure apparatus according the invention, the same or similar advantages and effects may be achieved as with the method according to the invention. Furthermore, the same or similar preferred embodiments as described with reference to the method according to the invention may apply to the position controller and the exposure apparatus according to the invention, achieving the same or similar effects as described with reference to the method according to the invention.

Although the present document describes the present control method and controller for the purpose of position control, it is noted that the same feed through may be applied to control any other output quantity. For example, the method, control device according to the present invention may control a temperature or any other suitable output quantity. An example of a thermal application is temperature matching between wafer handler and the wafer stages. A temperature difference between the submodules wafer handler and the wafer stages is required to be accurately controlled, whereas the individual temperatures of the submodules are of lower interest.

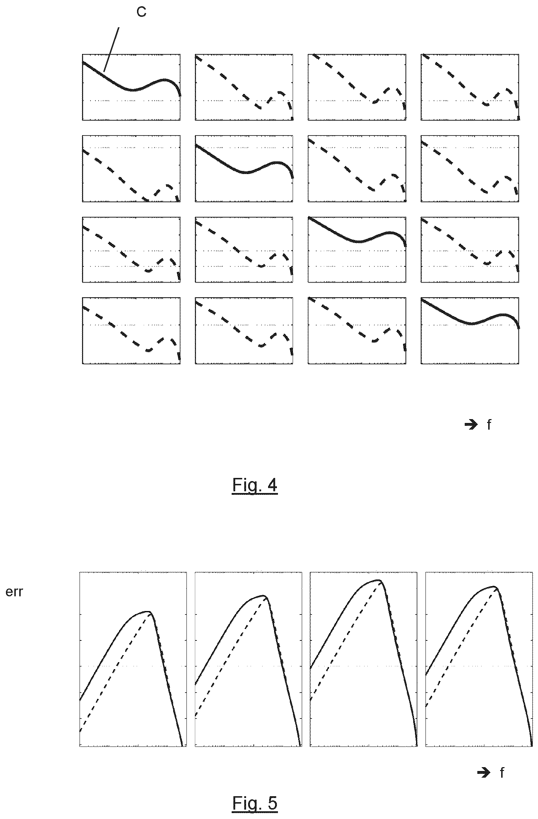

An example of the above described control method will be described with reference to Figures 4 - 7.

In the present example, a system comprising 4 modules is used as a starting point, i.e. .N = 4. For the sake of demonstration, it is assumed that all subsystems are identical rigid body systems, i.e., $P_{ii} = \dfrac{1}{ms^2}$ $\forall i$ and that there is no crosstalk, i.e., $P_{ij} = 0$ $\forall i,j,\ i \neq j$. In addition, all modules are initially controlled by identical Proportional Integrating Differentiating, PID, controllers that achieve a 300Hz bandwidth. Figure 4 depicts 4 x 4 frequency response diagrams in which the responses of the initial closed loop controllers C are shown as uninterrupted lines. The initial closed loop controllers do not provide any control interconnections between the modules, resulting in a PID response at the diagonal entries in the matrix of 4 x 4 responses and a zero response at the off diagonal entries in the matrix of 4 x 4 responses. The diagonal structure accordingly shows that there are no control interconnections between modules. The frequency responses according to the dashed lines will be explained further below.

Assume that the weight factors for weighting the contribution of the errors per module to an overall error, are set to W = [1 2 4 -3], which may be understood as an arbitrary choice for demonstration purposes in the present example. The initial transfer functions, for module 1 .... module 4, from disturbances $d_i$ to the combined error z are shown in uninterrupted lines in the frequency response diagrams as depicted in Figure 5. Figure 5 depicts diagrams of error err versus frequency f.

Reverting to the present development, the parameters in the matrices $\tilde{C},\ \hat{\bar{P}},\ Z, H$ in accordance with the control scheme as described above with reference to Figure 3 may be determined as follows:

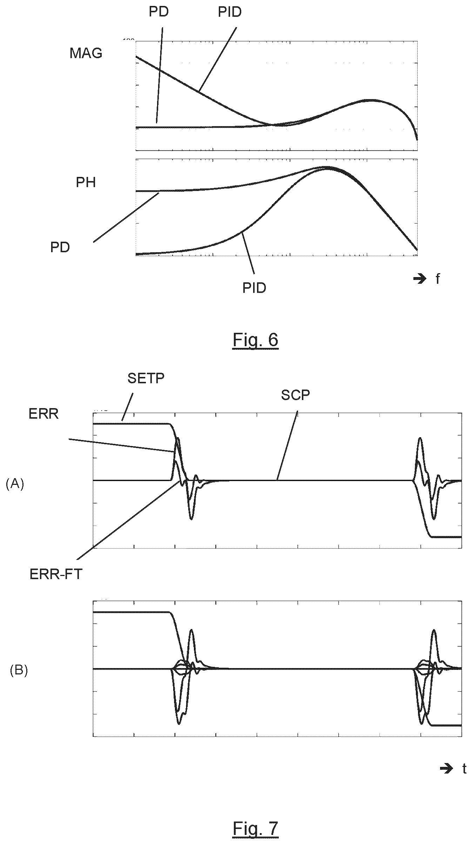

- The controller $\tilde{C}$: may be chosen as a different controller than the traditional controller C. This choice is made explicitly in this example to illustrate how settling time and cost can potentially be reduced while still improving combined performance. This is further discussed further below. The initial controller $\tilde{C}$ used for FT is the PD (no integral action) controller shown in Figure 6. Figure 6 depicts magnitude MAG and phase PH versus frequency f for the PID and PD initial controller.

- The plant model: is assumed equal to the true plant in this example, i.e., $\hat{\bar{P}} = \bar{P}$.
- The filter Z: is a unit delay.
- The matrix H = $H_w H_{dyn}$ is as described above, with $H_{dyn}$ a low-pass filter.

The resulting N-directional feed through controller is shown in dashed lines in Figure 4 for the off-diagonal terms. For the diagonal terms, the responses, i.e. the transfer functions of the resulting N-directional feed through controller, are the same as those of the initial controllers. The resulting N-directional feed through controller has a full structure, illustrating that all modules are interconnected in bilateral fashion. The resulting network structure corresponds to the scheme in Figure 2A, whereby each one of the 4 modules provides an error feed through to each of the other ones of the 4 modules. A further property is that the diagonal entries of the N-directional feed through controller $\overline{C}$ may be identical to those of the initial controller $C$, as a consequence of choosing $\tilde{C}$ as the specific PD controller.

The achieved combined error err is shown in dashed lines in Figure 5. Up to 200Hz, the improvement is a factor 4 (12dB) in for all 4 modules. For the pursued strategy whereby the feed through matrix entries are determined from the weighting factors as described above, the following is achieved for the low-frequency region: Using N-directional feed through control in the specific, illustrated configuration, an improvement of the combined performance scales proportionally with the number of subsystems $N$.

To analyze settling performance, setpoint-induced disturbance $d_1$ is introduced. The results for the combined error and the individual errors are shown in Figure 7. Figure 7 depicts a response versus time t of a scanning movement of a stage of an exposure apparatus. The Scanning phase in which the stage moves according to a scanning movement at constant velocity is indicated by SCP. The setpoint profile SETP has been scaled and included in the Figure. The combined error is depicted in Figure 7, a settling time of the combined error ERR of the original (without feedthrough) and the combined error ERR-FT with feedthrough is depicted showing that the N-directional feed through controller may significantly improve settling behavior for both the combined error and the individual errors. This may enable throughput increase.

The improvement may be understood as a consequence of using a PD controller in $\tilde{C}$, instead of a PID controller, by which slow integrator dynamics are eliminated.

The feed through control as described may enable a cost reduction. A performance improvement of a factor $N$ may potentially be 'exchanged' for a relaxation of the specifications of the individual modules, which may facilitate simpler, and lower cost, mechanical design and equipment. Second, the initial controller $\tilde{C}$ may be interpreted as a relaxed version of C, due to its relaxation of the high gain at low-frequences. Via the waterbed effect (Bode Sensitivity integral), the relaxation at low-frequences may result in larger margins at high-frequencies, which may provide more room for delays, uncertainties, or variations in dynamics. This may imply that it is typically less difficult to achieve a robust high bandwidth control loop with $\tilde{C}$ than with the traditional controller $C$. Again, this may reduce the design effort and may facilitate simpler, and cheaper, mechanical design and equipment.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

**1.** A method of positioning N modules in an exposure apparatus, wherein N > 2, the method comprising

- controlling a position of each of the N modules, comprising, for at least one of the N modules, feeding through a position error of the at least one of the N modules to at least two other ones of the N modules.

2. The method according to claim 1, wherein the feeding through comprises multiplying the position errors by a feed through filter matrix, the feed through filter matrix being an N x N matrix, wherein a non-diagonal term in the feed through filter matrix provides a feed through parameter from an error signal of a respective one of the N modules to another one of the N modules.

3. The method according to claim 2, wherein the feeding through comprises multiplying an output of the feed through filter matrix by an inverse of a parametric plant model matrix.

4. The method according to claim 3, wherein the feeding through comprises subtracting the output of the inverse of the parametric plant model matrix from closed loop controller output signals of closed loop controllers of the N modules.

5. The method according to any one of claims 2 - 4, wherein the feeding through comprises subtracting the output of the feed through filter matrix from the N error signals of the N modules.

6. The method according to any one of claims 2 - 4, wherein the feed through filter matrix comprises a weighting factor matrix.

7. The method according to claim 6, wherein each diagonal term of the weighting factor matrix is zero.

8. The method according to claim 6 or 7, wherein the weighting factor matrix comprises static parameters.

9. The method according to any one of claims 6 - 8, wherein the weighting factor matrix is determined from weighting factors w of the position error of each of the N modules onto a total error.

10. The method according to any one of claims 6 - 9, wherein the weighting factor matrix is determined from

$$H_w = \left( -\begin{bmatrix} \frac{1}{w_1} \\ \vdots \\ \frac{1}{w_N} \end{bmatrix} W + I \right) \frac{1}{N-1},$$

wherein $w_1 \dots w_N$ comprise the weighting factors of the position errors of each of the N modules and wherein W comprises a vector comprising the weighting factors $w_1 \dots w_N$.

11. The method according to any one of claims 2 - 10, wherein the feed through filter matrix further comprises a dynamic tuning matrix

12. The method according to claim 11, wherein the dynamic tuning matrix comprises a diagonal filter matrix.

13. The method according to any one of claims 2 - 12, wherein the feed through filter matrix further comprises a stability and causality filter matrix.

14. The method according to any one of claims 3 - 13 as far as dependent on claim 3, wherein the parametric plant model matrix comprises parametric plant models of the modules at the diagonal terms.

15. The method according to claim 14, wherein the parametric plant model matrix comprises interactions between the modules at off-diagonal terms.

16. The method according to any one of the preceding claims, wherein closed loop controller transfer functions of the N modules are comprised at diagonal terms of a closed loop controller matrix.

17. The method according to claim 16, wherein the closed loop controller matrix comprises zeros at the or each non-diagonal term.

**18.** A position controller configured to control a position of each one of N modules of an exposure apparatus, wherein N > 2, wherein the position controller is configured to, for at least one of the N modules, feed through a position error of the at least one of the N modules to at least two other ones of the N modules.

**19.** The position controller according to claim 18, wherein the feeding through comprises multiplying the position errors by a feed through filter matrix, the feed through filter matrix being an N x N matrix, wherein a non-diagonal term in the feed through filter matrix provides a feed through parameter from an error signal of a respective one of the N modules to another one of the N modules.

**20.** The position controller according to claim 19, wherein the position controller is configured in that the feed through comprises multiply an output of the feed through filter matrix by an inverse of a parametric plant model matrix.

**21.** The position controller according to claim 20, wherein the position controller is configured in that the feed through comprises subtract the output of the inverse of the parametric plant model matrix from closed loop controller output signals of closed loop controllers of the N modules.

**22.** The position controller according to any one of claims 19 - 21, wherein the position controller is configured in that the feed through comprises subtract the output of the feed through filter matrix from the N error signals of the N modules.

**23.** The position controller according to any one of claims 19 - 22, wherein the position controller is configured in that the feed through filter matrix comprises a weighting factor matrix.

**24.** The position controller according to claim 23, wherein each diagonal term of the weighting factor matrix is zero.

**25.** The position controller according to claim 23 or 24, wherein the weighting factor matrix comprises static parameters.

**26.** The position controller according to any one of claims 23 - 25, wherein the weighting factor matrix is determined from weighting factors w of the position error of each of the N modules onto a total error.

**27.** The position controller according to any one of claims 23 - 26, wherein the weighting factor matrix comprises

$$H_w = \left( - \begin{bmatrix} \frac{1}{w_1} \\ \vdots \\ \frac{1}{w_N} \end{bmatrix} W + I \right) \frac{1}{N-1},$$

wherein $w_1 \dots w_N$ comprise the weighting factors of the position errors of each of the N modules and wherein W comprises a vector comprising the weighting factors $w_1 \dots w_N$.

**28.** The position controller according to any one of claims 19 - 27, wherein the feed through filter matrix further comprises a dynamic tuning matrix.

**29.** The position controller according to claim 28, wherein the dynamic tuning matrix comprises a diagonal filter matrix.

**30.** The position controller according to any one of claims 19 - 29, wherein the feed through filter matrix further comprises a stability and causality filter matrix.

**31.** The position controller according to any one of claims 20 - 30 as far as dependent on claim 20, wherein the parametric plant model matrix comprises parametric plant models of the modules at the diagonal terms.

**32.** The position controller according to claim 31, wherein the parametric plant model matrix comprises interactions between the modules at off-diagonal terms.

**33.** The position controller according to any one of claims 19 - 32, wherein closed loop controller transfer functions of the N modules are comprised at diagonal terms of a closed loop controller.

**34.** The position controller according to claim 33, wherein the closed loop controller matrix comprises zeros at the or each non-diagonal term.

35. An exposure apparatus comprising the position controller according to any one of claims 18 - 34, wherein the N modules comprise at least N of a substrate table configured to support a substrate, a support configured to support a patterning device, a first optical element, a second optical element, a third optical element, a fourth optical element, a fifth optical element, and a sixth optical element.

36. The exposure apparatus according to claim 35, wherein the optical elements each comprise a mirror.

## FIG. 1

Fig. 2A    Fig. 2B    Fig. 2C

Fig. 3

C

→ f

Fig. 4

err

→ f

Fig. 5

PD    PID

MAG

PH

PD

PID

→ f

Fig. 6

SETP

ERR

SCP

(A)

ERR-FT

(B)

→ t

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4455784 A1